# EUROPEAN PATENT APPLICATION

(11) **EP 2 843 837 A1**
(43) Date of publication of application: **04.03.2015**
(21) Application number: 13182008.6
(22) Date of filing: 28.08.2013
(51) Int. Cl.: H03K 17/12, H02H 3/00, G01R 31/327

(54) **Solid state power controller and method for monitoring a solid state power controller**

(71) Applicant: Airbus Operations GmbH, 21129 Hamburg (DE)
(72) Inventor: Johannsen, Martin, 22889 Tangstedt (DE)
(74) Representative: Isarpatent

(57) **Abstract**

The present invention pertains to a solid state power controller, SSPC, device (1), comprising a switching system (2) including at least two switching paths (4a; 4b; 4n) connected in parallel, each of the at least two switching paths (4a; 4b; 4n) comprising a solid state power switching device (3a; 3b; 3n), a current sensor unit (5) including at least two shunt resistors (8a; 8b; 8n), each of the shunt resistors (8a; 8b; 8n) being coupled in one of the at least two switching paths (4a; 4b; 4n) in series to the respective solid state power switching device (3a; 3b; 3n), and a control device (6) having a sensor input terminal (6a) coupled to the current sensor unit (5), and a switch control output terminal (6b) coupled to the switching system (2). The control device (6) is configured to operate the switching system (2) in an active operational mode by keeping at least one of the solid state power switching devices (3a; 3b; 3n) closed.

## Description

The present invention relates to a solid state power controller and a method for monitoring a solid state power controller, in particular for aircraft power distribution architectures.

Modern aircraft power distribution architectures usually employ solid state power controller (SSPC) devices. The underlying principle for a SSPC is based upon one or more semiconductor switching devices coupled in series with a sensing device for detecting the switch current. Depending on the detected switch current by the sensing device, a control unit is configured to implement guarding functions for the switching devices in case of a failure in any of the components of the SSPC device.

Particularly in avionics it is desirable to provide a high level of system stability and reliability against failures in the power distribution. Therefore, a conventional measure is the provision of fusible links in the current path of the SSPC device to lower the system failure rates when the SSPC is subject to a failure.

One approach for disposing with the need for using a fusible link is to provide an additional under-rated electromechanical controller in the current path and in series to the switching devices of an SSPC device, such as for example disclosed in document US 2011/0222200 A1.

Other solutions involve providing parallel redundant current paths with redundant SSPC devices for a single load that are able to switch within the transparency time of the load, as for example taught in document US 8,344,545 B2.

However, there is still a need for solutions which maintaining reliability and safeguarding against failures of a SSPC device without the need for fusible links.

One object of the invention is therefore to reduce the complexity and weight of an SSPC device as well as the voltage drop over an SSPC device and at the same time maintain a high reliability and low failure rates of the SSPC device.

This object is achieved by an SSPC device having the features of claim 1, by an aircraft having the features of claim 5, and by a method for monitoring a solid state power controller having the features of claim 6.

A first aspect of the invention is directed to an SSPC device, comprising a switching system including at least two switching paths connected in parallel, each of the at least two switching paths comprising a solid state power switching device, a current sensor unit including at least two shunt resistors, each of the shunt resistors being coupled in one of the at least two switching paths in series to the respective solid state power switching device, and a control device having a sensor input terminal coupled to the current sensor unit, and a switch control output terminal coupled to the switching system. The control device is configured to operate the switching system in an active operational mode by keeping at least one of the solid state power switching devices closed.

A second aspect of the invention is directed to an aircraft, comprising an SSPC device according to the first aspect of the invention.

A third aspect of the invention is directed to a method for monitoring an SSPC device, the SSPC device comprising a switching system including at least two switching paths connected in parallel, each of the at least two switching paths comprising a solid state power switching device, a current sensor unit including at least two shunt resistors, each of the shunt resistors being coupled in one of the at least two switching paths in series to the respective solid state power switching device, and a control device having a sensor input terminal coupled to the current sensor unit, and a switch control output terminal coupled to the switching system. The method comprises operating the switching system in an active operational mode by keeping at least one of the solid state power switching devices closed; during the operational mode, opening at least one other solid state power switching device intermittently for a monitoring interval; and detecting a current through the switching system by reading out an output value of the current sensor unit during the monitoring intervals.

The idea on which the present invention is based is to provide multiple redundant switching paths for an SSPC device, each switching paths equipped with its own current sensor element, so that the need for a fusible link to increase reliability and safety can be obviated. This is achieved by detecting failures and defects only for a part of the switching paths at a time while the remaining switching paths are operated in a normal active operational mode in order to carry the load current. Therefore, the normal operational mode of the load to be fed is not impaired or interfered with, even while monitoring the SSPC device for failures or defects. In turn, the SSPC device may thus be monitored continuously.

Advantageously, there is no longer a need for a fusible link to be connected in series to the SSPC device for safety reasons. This will result in decreased space requirements as well as reduced voltage drop and tolerances in current detection. The trade-off wire size and weight can be reduced which is particularly advantageous for applications in aviation and avionics.

Moreover, the independency of the monitoring intervals from the active operational mode of the load leads to improved flexibility in monitoring the SSPC device. The monitoring intervals may thus be employed for both AC and DC power distribution architectures.

According to an embodiment of the SSPC device, the control device may be further configured to control the switching system to open at least one of the solid state power switching devices intermittently for a monitoring interval, and to detect a current through the switching system by reading out an output value of the current sensor unit during the monitoring intervals. This advantageously enables a monitoring of failures or defects of the SSPC device during normal use of the SSPC device.

According to a further embodiment of the SSPC device, the control device may be further configured to control the switching system to cyclically open different ones of the solid state power switching devices intermittently for a respective monitoring interval, and to detect a failure in one of the switching paths depending on the detected current in the respective monitoring intervals. That way, each of the switching paths may be monitored equally and continuously.

According to a further embodiment of the SSPC device, the resistivity values of the at least two shunt resistors are equal. This has the advantage that the shunt resistors may be dimensioned as being equal fractions of a shunt resistor serving as current sensor unit in series with the switching system overall. The shunt resistors according to the embodiment may thus be implemented with smaller power capability values since they only have to carry a fraction of the current through the switching system.

According to an embodiment of the method, the method may comprise cyclically opening different ones of the solid state power switching devices intermittently for a respective monitoring interval; and detecting a failure in one of the switching paths depending on the detected current in the respective monitoring intervals.

According to a further embodiment of the method, detecting a current through the switching system may comprise reading out respective current values of shunt resistors during the respective monitoring intervals.

The invention will be explained in greater detail with reference to exemplary embodiments depicted in the drawings as appended.

The accompanying drawings are included to provide a further understanding of the present invention and are incorporated in and constitute a part of this specification. The drawings illustrate the embodiments of the present invention and together with the description serve to explain the principles of the invention. Other embodiments of the present invention and many of the intended advantages of the present invention will be readily appreciated as they become better understood by reference to the following detailed description. The elements of the drawings are not necessarily to scale relative to each other. Like reference numerals designate corresponding similar parts.
Fig. 1 schematically illustrates an aircraft including an SSPC device according to an embodiment of the invention.
Fig. 2 schematically illustrates a power distribution architecture for an aircraft according to a further embodiment of the invention.
Fig. 3 schematically illustrates an SSPC device according to a further embodiment of the invention.
Fig. 4 schematically illustrates a method for monitoring an SSPC device according to a further embodiment of the invention.

In the figures, like reference numerals denote like or functionally like components, unless indicated otherwise. Any directional terminology like "top", "bottom", "left", "right", "above", "below", "horizontal", "vertical", "back", "front", "clockwise", "counter-clockwise" and similar terms are merely used for explanatory purposes and are not intended to delimit the embodiments to the specific arrangements as shown in the drawings.

Although specific embodiments have been illustrated and described herein, it will be appreciated by those of ordinary skill in the art that a variety of alternate and/or equivalent implementations may be substituted for the specific embodiments shown and described without departing from the scope of the present invention. Generally, this application is intended to cover any adaptations or variations of the specific embodiments discussed herein.

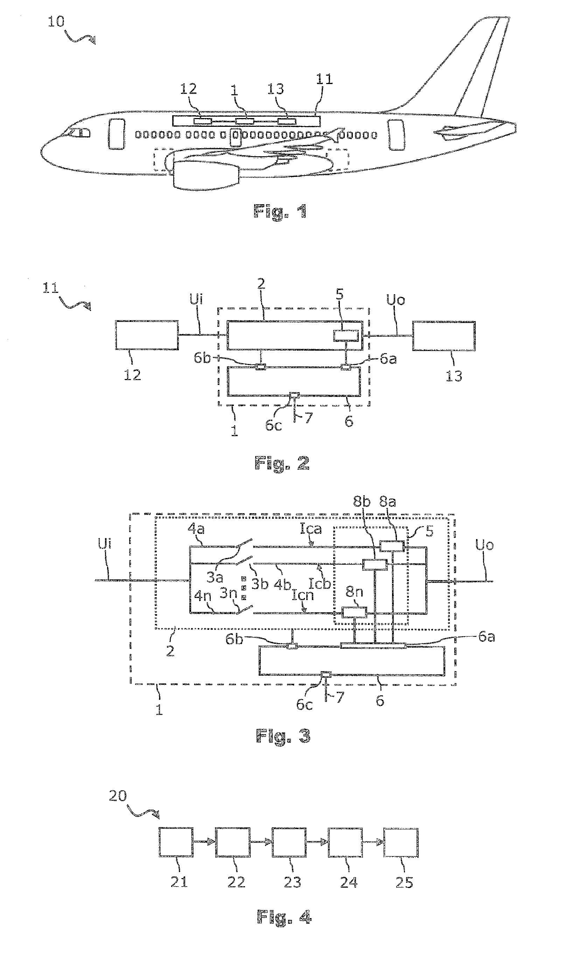

Fig. 1 shows a schematic illustration of an aircraft 10 having an SSPC device 1. The aircraft 10 by way of example comprises a power distribution architecture 11 having a power source 12, for example a generator, a fuel cell or a high voltage battery, and an electrical load 13, which may be any aircraft system or subsystem that draws electrical power in use.

The power source 12 and the load 13 are coupled by means of a solid state power controller (SSPC) device 1 which may be a hardware component including one or more controllable circuit breaking components which have to be enabled for the SSPC device to provide power from the power source 12 to a particular electrical load 13. The SSPC device 1 may be under control of a controlling unit that monitors the operational state of the elements of the SSPC device 1. In particular, when any failure, defect or irregularity is detected that might lead to potential overloads or other harm to the associated electrical components of the power distribution architecture 11 the controlling unit is able to take measures to shut down the power source 12 and/or the SSPC device 1 for safety reasons. Usually, the required failure rates and failure response times are bounded by upper limits set by official regulations of aviation associations. Therefore, the SSPC device 1 is designed with corresponding inbuilt failsafe mechanisms to meet the officially prescribed limits.

Fig. 2 schematically shows a power distribution architecture 11 for an aircraft, for example the aircraft 10 in Fig. 1. The power distribution architecture 11 may for example be employed in primary power distribution networks of the aircraft. The power distribution architecture 11 may be used for AC power distribution networks as well as for DC power distribution networks.

A power source 12, for example a generator, a fuel cell or a high voltage battery or accumulator, may supply an input voltage Ui to an SSPC device 1. The SSPC device 1 may include semiconductor devices configured to control the voltage and/or current supplied to a load 13. The SSPC device 1 may include a switching system 2 that is configured to selectively connect or disconnect the power source 12 from the load 13. Incorporated into switching system 2 is a current sensor unit 5 which is adapted to detect the current being momentarily supplied to the load 13.

A control device 6 is coupled to both the switching system 2 via a switch control output terminal 6b and the current sensor unit 5 via a sensor input terminal 6a. The control device 6 is configured to perform supervisory and diagnostic functions in order to identify overload conditions and prevent short circuits. The SSPC device 1 may designed to switch alternating current (AC) voltages. It may also be possible for the SSPC device 1 to switch direct current (DC) voltages. As a further alternative, the SSPC device 1 may be an AC/DC controller which is configured to switch both AC and DC voltages. To that end, the control device 6 may comprise any type of controlling element that is capable to performing logical operations. For example, the control device 6 may be a microprocessor, a microcontroller, an ASIC, an FPGA or a CPLD. The control device 6 may in particular comprise one or more of an arithmetic logic unit (ALU), a memory component, a timer component, a counter component and input/output (I/O) ports. The control device 6 may specifically comprise a state signal output terminal 6c for outputting state signals 7 indicating the operational state of the SSPC device 1 as well as various fault, failure or defect conditions to an external system, such as an aircraft control system.

Fig. 3 schematically shows an SSPC device 1 which may for example be employed in a power distribution architecture 11 for an aircraft, such as the aircraft 10 in Fig. 1. The SSPC device 1 may in particular be employed in the power distribution architecture 11 as shown in Fig. 2.

The switching system 2 of the SSPC device 1 comprises two or more switching branches or switching paths 4a, 4b, ..., 4n which are coupled in parallel to each other. In the exemplary embodiment of Fig. 3 there are three switching paths 4a, 4b, ..., 4n shown, however, as will be apparent to the skilled person in the art, any other number of switching paths 4a, 4b, ..., 4n greater than one may be employed as well. Each of the switching paths 4a, 4b, ..., 4n comprises a respective solid state power switching device 3a, 3b, ..., 3n, for example a semiconductor switching device such as a MOSFET, an IGBT, a JFET, a BJT or any other suitable power semiconductor switching element. The solid state power switching devices 3a, 3b, ..., 3n may for example be implemented on the same chip substrate. Furthermore, the current sensor unit 5 includes at least two shunt resistors 8a, 8b ..., 8n, each of the shunt resistors 8a, 8b ..., 8n being coupled in one of the switching paths 4a, 4b, ..., 4n in series to the respective solid state power switching device 3a, 3b, ..., 3n.

The control device 6 is configured to control the switching operation of the solid state power switching devices 3a, 3b, ..., 3n via switching signals outputted at the switch control output terminal 6b to the switching system 2. For example, it may be possible for the control device 6 to generate a common switching signal which is configured to control the solid state power switching devices 3a, 3b, ..., 3n to switch in unison. Alternatively or additionally, it may be possible for the control device 6 to generate distinct switching signals for each of the solid state power switching devices 3a, 3b, ..., 3n in order control the solid state power switching devices 3a, 3b, ..., 3n to switch disjunctive from each other.

In order to generate the switching signals the control device 6 is adapted to receive detection values of a current Ica, Icb, ..., Icn momentarily flowing through each of the respective switching paths 4a, 4b, ..., 4n of the switching system 2. The detection of the current may for example be performed using the respective shunt resistor 8a, 8b, ..., 8n in the current sensor unit 5 over which a respective shunt voltage may be measured. The SSPC currents Ica, Icb, ..., Icn may then be calculated from the measured shunt voltages depending on the known resistivity values of the shunt resistors 8a, 8b, ..., 8n. It may also be possible to use alternative solutions or measures to detect the SSPC currents Ica, Icb, ..., Icn in the current sensor unit 5, for example Hall effect IC sensors or Rogowski coils.

The control device 6 is configured to operate the switching system 2 in an active operational mode by keeping at least one of the solid state power switching devices 3a, 3b, ..., 3n closed so that the load 13 is provided with an output voltage Uo and a concomitant current from the power source 12 over the respectively activated switching path 4a, 4b, ..., 4n. The control device 6 needs to test the active components of the SSPC device 6 periodically in order to ensure the reliability requirements. The control device 6 may for this purpose be configured to control the switching system 2 to open at least one of the solid state power switching devices 3a, 3b, ..., 3n which differs from the previously closed solid state power switching device(s) 3a, 3b, ..., 3n intermittently for a monitoring interval, and to detect a current through the switching system 2 by reading out an output value of the current sensor unit 5 during the monitoring intervals. The duration of the monitoring interval may in this case be chosen freely, since the normal active operational mode of the load 13 is not affected by the opened switching path under monitoring.

The monitoring interval can advantageously be performed during the active operational mode, that is during the load 13 is supplied with electrical power from the power source 12. The control device 6 is thus able to test the SSPC device 1 for failures or defects without having to temporarily terminate the active operational mode of the load 13.

The control device 6 may be further configured to control the switching system 2 to cyclically open different ones of the solid state power switching devices 3a, 3b, ..., 3n intermittently for a respective monitoring interval. That way, the control device 6 may detect a failure in one of the switching paths 4a, 4b, ..., 4n depending on the detected current in the respective monitoring intervals.

The resistivity values of the shunt resistors 8a, 8b, ..., 8n may be chosen to be equal, in particular a respective fraction of a resistivity value of a shunt resistor that would have to be used in series to the whole switching system 2, depending on the expected maximum current values. Alternatively, it may also be possible to choose different values for the resistivity of the shunt resistors 8a, 8b, ..., 8n, for example when one of the switching paths 4a, 4b, ..., 4n is designed for a higher maximum current than the remaining ones.

Fig. 4 shows a schematical illustration of a method 20 for monitoring an SSPC device. The method 20 may for example be used to monitor the SSPC device 1 of Fig. 3, for example when employed in a power distribution architecture 11 as illustrated in Fig. 2 and/or in an aircraft 10 as illustrated in Fig. 1.

At a first step 21, the switching system 2 of the SSPC device 1 is operated in an active operational mode by keeping the at least one solid state power switching device 3a, 3b, ..., 3n closed. An operational mode may comprise the feeding of electrical power from the power source 12 to the electrical load 13 for purposes of operating the load 13 in its intended function.

During the operational mode, the second step 22 of opening the at least one solid state power switching device 3a, 3b, ..., 3n may be performed intermittently. The opening of the solid state power switching devices 3a, 3b, ..., 3n may be performed for a monitoring interval.

In a third step 23, a current through the switching system 2 may be detected by reading out an output value of the current sensor unit 5 during the monitoring intervals. The read-out current may then be compared to expected values in order to detect abnormal or potentially hazardous operation conditions.

For example, for all cases where there is no current or a current below a certain minimum threshold is detected when the respective solid state power switching device 3a, 3b, ..., 3n of the monitored switching path 4a, 4b, ..., 4n is closed or at least addressed to be closed, either the respective shunt resistor 8a, 8b, ..., 8n in that switching path 4a, 4b, ..., 4n may be short-circuited or the respective solid state power switching device 3a, 3b, ..., 3n fails to close properly. On the other hand, if the detected current is above a certain maximum threshold when the solid state power switching device 3a, 3b, ..., 3n of the respectively monitored switching path 4a, 4b, ..., 4n is closed, the respective shunt resistor 8a, 8b, ..., 8n is assumed to be defective. All of those cases are not immediately detrimental to the safety and reliability of the SSPC device 1, since the respective switching paths 4a, 4b, ..., 4n to be found defective or in failure may be omitted for the active operational mode of the load 13. The remaining redundant switching paths 4a, 4b, ..., 4n may thus compensate for the defective path. The control device 6 may issue in those cases a respective state signal 7 at the state signal output terminal 6c in order to alert other aircraft systems to put the SSPC device 1 under maintenance during the next maintenance and repair cycle.

If, however, the detected current is above a certain maximum threshold when the solid state power switching device 3a, 3b, ..., 3n of the respectively monitored switching path 4a, 4b, ..., 4n is to be opened, the respective solid state power switching device 3a, 3b, ..., 3n is assumed to be in short-circuit. In such a case, the assumption must be made that an overcurrent cannot be reliably detected in time and, hence, not prevented. For this case, the control device 6 may issue a warning signal to shut down the SSPC device 1 for safety reason or to disable the active operational mode of the SSPC device 1 by itself.

In order to continuously and equally monitor all of the switching paths 4a, 4b, ..., 4n, the method 20 may further comprise at step 24 cyclically opening different ones of the solid state power switching devices 3a, 3b, ..., 3n intermittently for a respective monitoring interval. In a step 25, a failure in one of the switching paths 4a, 4b, ..., 4n may then be detected depending on the detected current in the respective monitoring intervals. The detecting of a current through the switching system 2 may in this case comprise reading out respective current values of the respective shunt resistors 8a, 8b, ..., 8n during the respective monitoring intervals.

The method 20 may make the use of an additional fusible link obsolete. Each of the above mentioned failure cases may be compensated by shedding the connected power source 12 in time and still be able to meet the official limits for the required maximum failure rates.

In the foregoing detailed description, various features are grouped together in one or more examples or examples with the purpose of streamlining the disclosure. It is to be understood that the above description is intended to be illustrative, and not restrictive. It is intended to cover all alternatives, modifications and equivalents. Many other examples will be apparent to one skilled in the art upon reviewing the above specification.

The embodiments were chosen and described in order to best explain the principles of the invention and its practical applications, to thereby enable others skilled in the art to best utilize the invention and various embodiments with various modifications as are suited to the particular use contemplated. In the appended claims and throughout the specification, the terms "including" and "in which" are used as the plain-English equivalents of the respective terms "comprising" and "wherein," respectively. Furthermore, "a" or "one" does not exclude a plurality in the present case.

### List of reference numerals and signs

- 1: SSPC device
- 2: Switching system
- 3a: Switching device
- 3b: Switching device
- 3n: Switching device
- 4a: Switching path
- 4b: Switching path
- 4n: Switching path
- 5: Current sensor unit
- 6: Control device
- 6a: Sensor input terminal
- 6b: Switch control output terminal
- 6c: State signal output terminal
- 7: State signal
- 8a: Shunt resistor
- 8b: Shunt resistor
- 8c: Shunt resistor
- 10: Aircraft
- 11: Power distribution architecture
- 12: Power source
- 13: Load
- 20: Method
- 21: Method step
- 22: Method step
- 23: Method step
- Ic: SSPC current
- Ica: SSPC switching path current
- Icb: SSPC switching path current
- Icn: SSPC switching path current
- Ui: Input voltage
- Uo: Output voltage

## Claims

1. Solid state power controller, SSPC, device (1), comprising:
a switching system (2) including at least two switching paths (4a; 4b; 4n) connected in parallel, each of the at least two switching paths (4a; 4b; 4n) comprising a solid state power switching device (3a; 3b; 3n);
a current sensor unit (5) including at least two shunt resistors (8a; 8b; 8n), each of the shunt resistors (8a;
8b; 8n) being coupled in one of the at least two switching paths (4a; 4b; 4n) in series to the respective solid state power switching device (3a; 3b; 3n); and
a control device (6) having a sensor input terminal (6a) coupled to the current sensor unit (5), and a switch control output terminal (6b) coupled to the switching system (2),
wherein the control device (6) is configured to operate the switching system (2) in an active operational mode by keeping at least one of the solid state power switching devices (3a; 3b; 3n) closed.

2. SSPC device (1) according to claim 1, wherein the control device (6) is further configured to control the switching system (2) to open at least one of the solid state power switching devices (3a; 3b; 3n) intermittently for a monitoring interval, and
wherein the control device (6) is further configured to detect a current through the switching system (2) by reading out an output value of the current sensor unit (5) during the monitoring intervals.

3. SSPC device (1) according to claim 2, wherein the control device (6) is further configured to control the switching system (2) to cyclically open different ones of the solid state power switching devices (3a; 3b; 3n) intermittently for a respective monitoring interval, and
wherein the control device (6) is further configured to detect a failure in one of the switching paths (4a; 4b; 4n) depending on the detected current in the respective monitoring intervals.

4. SSPC device (1) according to one of the claims 1 to 3,
wherein the resistivity values of the at least two shunt resistors (8a; 8ba; 8n) are equal.

5. Aircraft, comprising an SSPC device (1) according to one of the claims 1 to 4.

6. Method (20) for monitoring a solid state power controller, SSPC, device (1), the SSPC device (1) comprising a switching system (2) including at least two switching paths (4a; 4b; 4n) connected in parallel, each of the at least two switching paths (4a; 4b; 4n) comprising a solid state power switching device (3a; 3b; 3n), a current sensor unit (5) including at least two shunt resistors (8a; 8b; 8n), each of the shunt resistors (8a; 8b; 8n) being coupled in one of the at least two switching paths (4a; 4b; 4n) in series to the respective solid state power switching device (3a; 3b; 3n), and a control device (6) having a sensor input terminal (6a) coupled to the current sensor unit (5), and a switch control output terminal (6b) coupled to the switching system (2), the method (20) comprising:
operating (21) the switching system (2) in an active operational mode by keeping at least one of the solid state power switching devices (3a; 3b; 3n) closed;
during the operational mode, opening (22) at least one other solid state power switching device (3a; 3b; 3n) intermittently for a monitoring interval; and detecting (23) a current through the switching system (2) by reading out an output value of the current sensor unit (5) during the monitoring intervals.

7. Method (20) according to claim 6, further comprising:
cyclically (24) opening different ones of the solid state power switching devices (3a; 3b; 3n) intermittently for a respective monitoring interval; and
detecting (25) a failure in one of the switching paths (4a; 4b; 4n) depending on the detected current in the respective monitoring intervals.

8. Method (20) according to claim 7, wherein detecting (23) a current through the switching system (2) comprises reading out respective current values of shunt resistors (8a; 8b; 8n) during the respective monitoring intervals.
